Europäisches Patentamt

European Patent Office

Office européen des brevets

(11) Publication number : **0 494 753 A2**

(12) **EUROPEAN PATENT APPLICATION**

(21) Application number : **92300110.1**

(22) Date of filing : **07.01.92**

(51) Int. Cl.$^5$ : **C01B 33/03,** C01B 31/36, C23C 16/24, C23C 16/32, C23C 16/56

(30) Priority : **07.01.91 US 638473**

(43) Date of publication of application : **15.07.92 Bulletin 92/29**

(84) Designated Contracting States : **CH DE FR GB IT LI**

(71) Applicant : **CVD INCORPORATED 185 New Boston Street Woburn Massachusetts 01801 (US)**

(72) Inventor : **Goela, Jitendra S. 12 Messina Drive Andover, Massachusetts 01810 (US)** Inventor : **Taylor, Raymond L. 1413 Sheffield Way Saugus, Massachusetts 01906 (US)**

(74) Representative : **Bankes, Stephen Charles Digby et al BARON & WARREN 18 South End Kensington London W8 5BU (GB)**

(54) Chemical vapor deposition-produced silicon and silicon carbide having improved optical properties.

(57) The optical transmission of chemical vapor deposition-produced silicon is dramatically enhanced by annealing at temperatures in the range of from 1300°C to 1500°C. Chemical vapor deposited silicon carbide, which is not ordinarily transmitting of infrared light, may be made transmitting through annealing at temperatures in the range of from 1800°C to 2600°C.

EP 0 494 753 A2

The present invention is directed to silicon and silicon carbide, each produced by chemical vapor deposition processes, each having improved optical properties, and to a method of producing the same.

## BACKGROUND OF THE INVENTION

Silicon (Si) is a widely used material in the semiconductor industry. Over the past twenty years, properties of silicon of direct relevance to semiconductor devices have been extensively studied and documented in the literature. These properties are primarily those of a single crystal silicon. However, recently new and large scale applications of silicon, such as an optical substrate for infrared windows, lenses and domes in the 3-5 $\mu$m wavelength range, LIDAR (Light Detection and Ranging) mirrors, solar collectors and concentrators, cathode covers (in the reactive ion etching systems), and astronomical mirrors, have been proposed. For many of these applications, silicon blank sizes of interest are in the one-meter range. Single crystal silicon is unsuitable for these applications because of the current size limitation, which is several tens of centimeters in diameter. The sintered and hot processed forms of Si are usually porous and do not produce a high quality optical surface on polishing. Other fabrication technologies, such as physical vapor deposition and casting, also produce relatively small size Si blanks. Further, all the aforementioned technologies, except physical vapor deposition, cannot be used to apply an optical grade Si coating on other substrates such as SiC, graphite, and $Si_3N_4$.

Recently, a scalable, cost effective, and subatmospheric pressure chemical vapor deposition (CVD) process was developed to fabricate polycrystalline Si for optics, e.g., mirror, applications. (J.S. Goela and R.L. Taylor, "Chemical Vapor Deposition for Silicon Cladding on Advanced Ceramics," J. Am. Cer. Soc. 72(9), 1747-50 (1989); J.S. Goela and R.L. Taylor, "Rapid Fabrication of Lightweight Ceramic Mirrors via Chemical Vapor Deposition," App. Phys. Lett., 54(25) 2512-14 (1989); J.S. Goela and R.L. Taylor, "Fabrication of Lightweight Si/SiC LIDAR Mirrors," in SPIE Proceedings, Vol. 1062, International Society for Optical Engineering, Bellingham, WA, 1989, pp. 37-49; J.S. Goela and R.L. Taylor, "CVD Replication for Optics Applications," in SPIE Proceedings, Vol. 1047, International Society for Optical Engineering, Bellingham, WA, 1989, pp. 198-210; J.S. Goela, M.A. Pickering, R.L. Taylor, B.W. Murray and A. Lompado, "Chemically Vapor Deposited Silicon and Silicon Carbide Optical Substrates for Severe Environments," in SPIE PROCEEDINGS, Vol. 1330, International Society for Optical Engineering, Bellingham, WA, 1990; J.S. Goela and R.L. Taylor, "Large Scale Fabrication of Lightweight Si/SiC LIDAR Mirrors," in SPIE Proceedings, Vol. 1118, International Society for Optical Engineering, Bellingham, WA, 1989, pp. 14-24.) This CVD process is based upon the pyrolysis of $SiHCl_3$ in excess $H_2$ to yield polycrystalline Si and can be used either to fabricate bulk material or coat other substrates with thin layers of optical grade Si. This CVD process was successfully scaled from a hot wall horizontal deposition chamber which yielded Si blanks 30 cm x 9 cm x 0.3 cm to a cold wall vertical deposition chamber which produced Si flat plates 30 cm x 25 cm x 0.64 cm. Important scaling laws were developed which show that there is no physical limitation which will prevent the scaling of this CVD process to produce Si plates several meters in diameter. Currently available production reactors have the potential to produce Si plates up to 1.5 m diameter.

The characterization of CVD polycrystalline Si showed that most of its properties, except thermal conductivity, are approximately the same as those of the single crystal Si. Due to the effects associated with grain boundaries, the thermal conductivity of CVD-Si is less than that of the single crystal Si. However, because CVD-Si is a fine grain polycrystalline material, it does not exhibit failure along the cleavage planes as does the single crystal Si. CVD-Si also exhibited excellent polishability. For example, a surface finish less than 0.2 nm root mean square (RMS) was routinely produced.

Although CVD-Si produced by the above-described method exhibited superior properties, it also showed a large scattering loss in the near infrared (1.0 $\mu$m-7.0 $\mu$m) wavelength region making it unsuitable for those applications that make use of its transmissive properties (windows, domes, lenses). CVD-Si fabricated by other CVD processes exhibit better transmission in the near infrared region, but these materials are inferior in other optical and mechanical properties. Further, these other CVD processes have not been scaled to produce large size Si blanks. Thus, it will be of interest to improve infrared transmission of CVD-Si produced by the above-described method without degrading its other unique properties.

It would also be desirable to have optically-transmitting polycrystilline silicon carbide produced by CVD processes. SiC is a large band gap material, and single crystal SiC is transparent in the visible and infrared region to a wavelength of about 10 $\mu$m. Because the CVD process yields a highly pure, theoretically dense, void free, polycrystalline SiC, in principal, it should also exhibit the above property. However, moderately thick samples of CVD-SiC (thickness > 0.1-inch) transmits neither in the visible region nor in the infrared region. This lack of transmission may be due to non-stoichiometry giving rise to excess carbon or excess Si, presence of impurities, residual stresses, and/or crystal disorder. If polycrystalline silicon carbide produced by CVD processes could be made optically transmitting, there are potentially valuable optical applications of this material, particularly as infrared window material.

2

EP 0 494 753 A2

## SUMMARY OF THE INVENTION

In accordance with the present invention, optical properties of polycrystalline CVD-produced silicon (CVD-Si) and polycrystalline CVD-produced silicon carbide (CVD-SiC) are optically enhanced, i.e., are given improved transmission of light, particularly in the near infrared regions, by annealing these materials at temperatures approaching their melting temperatures. In the case of CVD-produced silicon, annealing temperatures are in the range of between about 1300°C and about 1400°C; in the case of silicon carbide, annealing temperatures are in the range of between about 1800°C and about 2600°C, most preferably in the range of from about 1800°C to about 2300°C.

## BRIEF DESCRIPTION OF THE DRAWINGS

FIGURE 1 shows transmission traces of unannealed CVD-Si samples.
FIGURE 2 is an X-ray diffraction scan of an unannealed CVD-Si sample.
FIGURE 3 shows microstructure of unannealed CVD-Si.
FIGURE 4 is a comparison of infrared transmission of annealed and unannealed CVD-Si.
FIGURE 5 is a comparison of infrared transmission of annealed and unannealed CVD-Si.
FIGURE 6 is an infrared transmission trace of an annealed sample of CVD-Si.
FIGURE 7 is an infrared transmission trace of an annealed sample of CVD-Si.
FIGURE 8 is a micrograph comparing the microstructure of (a) unannealed and (b) annealed CVD-Si.
FIGURE 9 is a micrograph comparing the microstructure of annealed CVD-Si at two locations.
FIGURE 10 is a comparison of X-ray diffraction of (a) unannealed and (b) annealed CVD-Si.
FIGURE 11 is a comparison of X-ray diffraction of (a) unannealed and (b) annealed CVD-Si.
FIGURE 12 is an infrared transmission trace of an annealed CVD-Si sample.
FIGURE 13 is a transmission trace of an annealed sample of CVD-Si.
FIGURE 14 is a micrograph comparing the microstructure of (a) unannealed and (b) annealed CVD- Si.
FIGURE 15 is an infrared transmission trace of an annealed CVD-SiC sample.
FIGURE 16 is an infrared transmission trace comparing annealed and unannealed CVD-SiC samples.

## DETAILED DESCRIPTION OF CERTAIN PREFERRED EMBODIMENTS

It is found that annealing both CVD-produced polycrystalline silicon and polycrystalline silicon carbide at temperatures approaching their melting points substantially enhances the optical qualities of these materials while retaining many of their other benefits, particularly desirable mechanical characteristics.

CVD-Si, particularly silicon produced by the pyrolysis reaction of $SiHCl_3$ and $H_2$ at deposition temperatures below about 1100°C, has improved optical properties if annealed at temperatures of between about 1300°C and about 1400°C. The annealing substantially enhances the optical transmission properties, particularly transmission in the near infrared, of the CVD-produced silicon. At the same time, mechanical properties are either not degraded by the annealing or degraded only slightly. In particular, it is found that the annealing process does not change the average values of hardness and flexural strength, within the accuracy of measurement, while the elastic modulus is decreased by only about 10% by the annealing process. Annealed CVD-Si samples may have Knoop hardness of between 800-1000 Kg $mm^{-2}$ and preferably above about 850 Kg $mm^{-2}$, flextural strengths of above about 20-40 Ksi and preferably above about 24 Ksi, and elastic moduli of above about 20-24 x $10^6$ psi and preferably above about 21 x $10^6$ psi. The annealed CVD-produced silicon has optical properties similar to single crystal silicon. Unlike single crystal silicon, polycrystalline, CVD-produced silicon is scalable to several meters and then can be used in a variety of window applications. Furthermore, whereas single crystal silicon has cleavage planes which cause it to fail catastrophically under stresses frequently encountered in window applications, CVD-produced silicon does not have cleavage planes and has mechanical characteristics suitable for window applications. The CVD-produced silicon may either be a relatively thick layer which can stand by itself as an optically-transmitting material or may be a layer on a composite optically-transmitting material. Optically-transmitted substrates on which silicon may be deposited by CVD and subsequently annealed include, but are not limited to SiC, $Si_3N_4$, BN, $Y_2O_3$, $CaL_2S_4$.

Annealing times will depend upon a number of factors, such as sample thickness, whether the sample is a stand-alone sample, whether it is a layer on another substrate, and whether it is sandwiched between other materials in the annealing unit. The examples below show experiments in which annealing times were sufficiently long, but this is not to say that shorter annealing times might not also be successful.

Annealed CVD-Si, produced in accordance with the present invention, has attenuation coefficient at a wavelength of 3500 $cm^{-1}$ of at most 0.30 $cm^{-1}$ and lower to 0.01 $cm^{-1}$. This is a tremendous improvement relative

3

to unannealed CVD-produced silicon which typically has an absorption coefficient of no more than about 10 $cm^{-1}$ at 3500 $cm^{-1}$. Optical attenuation coefficients at 3500 $cm^{-1}$ are used herein as a suitable comparison of optically transmitting materials because this is a wavelength at which infrared window materials are frequently required to exhibit good optical transmittance. However, as will be seen from the examples, including the accompanying figures, optical transmittance across a wide range of visible and infrared wavelengths is improved by annealing CVD-produced silicon.

While Applicants do not wish to be bound by theory as to why the annealed CVD-Si has improved optical qualities, there is good evidence that the annealing process changes the crystalline morphology of the CVD-Si. X-ray diffraction patterns indicate that annealing changes the crystal structure from high (220) orientation to a random orientation. Examination of surface morphology indicates that annealing of CVD-Si changes the bimodal grain size distribution to a more random distribution with the average grain size remaining the same. Further, the columnar structure characteristic of CVD growth is also changed by annealing into a more random structure. These observations indicate that annealed CVD-Si samples are more isotropic in crystalline structure than unannealed CVD-Si.

Annealing is accomplished by merely heating the CVD-Si in the presence of a non-reactive atmosphere. The annealing may be done within the reactor where the silicon was produced by chemical vapor deposition. It appears that the annealing may be done immediately after a deposition that was performed at a somewhat lower temperature. Alternatively, silicon produced by CVD and then brought to ambient temperature may be annealed by reheating to the annealing temperature range.

The factors which make it desirable to have a more optically transmitting CVD-Si material also apply to the desirability of having optically transmitting CVD-SiC. In fact, transmitting CVD-SiC may prove to be even more valuable than CVD-Si in window applications. CVD-SiC is a polycrystalline material that is effectively opaque throughout the visible and infrared regions. It has been found that annealing CVD-SiC provides attenuation coefficients of at most about 4 $cm^{-1}$ at 3500 $cm^{-1}$. Although this material is not highly transmitting, the fact that it transmits light at all is a dramatic improvement over non-transmitting, unannealed CVD-SiC. The mechanical characteristics of SiC may make this material especially useful as a thin coating on infrared window material. Annealed CVD-Si samples may have Knoop hardness of above about 2000-2500 Kg $mm^{-2}$ and preferably above about 2500 Kg $mm^{-2}$. Optically-transmitted substrates on which silicon carbide may be deposited by CVD and subsequently annealed include, but are not limited to SiC, BN, $Al_2O_3$.

Annealing temperatures for CVD-SiC are in the range of between about 1800°C and about 2600°C, preferably in the range of about 1800-2300°C, most preferably in the range of 2200°C to 2300°C. Because SiC undergoes a phase transition from its beta to its alpha form at about 2300°C, for many applications it may be advisable to anneal at below about 2300°C. Furthermore, the highest annealing temperatures may be difficult to achieve in many available annealing units.

Again, annealing may be done in any suitable high temperature-producing apparatus, including the deposition reactor. It is not at this time known whether it is necessary, but CVD-SiC annealing experiments have been conducted in the presence of silicon in an inert atmosphere. Silicon boils at 2355°C and has a high vapor pressure throughout the annealing temperature range of CVD-SiC, and it was felt that without the presence of external silicon vapor in the annealing atmosphere, significant amounts of silicon vaporizes from the silicon carbide. This fact was confirmed by annealing the SiC samples at 2200°C in the presence of Ar. A thick coating of carbon was detected on the annealed SiC samples.

Again, annealing times in relation to various factors, such as sample thickness, underlying substrate, etc., have not been determined. It was found, however, that in some thicker samples, insufficient annealing times resulted in samples that were optically transmitting toward the surface, yet still opaque interior of the surface. The examples below describe experiments where annealing times were sufficient.

The reason why the opaque CVD-SiC becomes optically transmitting upon annealing is not known and Applicants are not bound by any theory. The change in crystalline morphology that is clearly seen in annealed silicon has not been seen in silicon carbide samples, although a change in crystalline morphology cannot be ruled out. One possible explanation is that impurities are removed through vaporization at the annealing temperatures. Such impurities might include slight excesses of carbon or silicon beyond the theoretical I:I stoichiometric ratio.

The invention will now be described in greater detail by way of specific examples.

EXAMPLE 1

FABRICATION OF POLYCRYSTALLINE Si via CVD

Polycrystalline Si was fabricated by reacting trichlorosilane ($SiHCl_3$) with excess $H_2$ in a hot wall CVD reactor according to the following reaction:

$$SiHCl_3(g) + H_2(g) \rightarrow Si(s) + 3HCl(g)$$

where g and s refers to gas and solid, respectively. Because $SiHCl_3$ is a liquid at room temperature, it was carried to the deposition area using the following two conditions: (1) Argon was used as a carrier gas and bubbled through the $SiHCl_3$ cylinder which was maintained at about 20°C and (2) the $SiHCl_3$ cylinder was heated to 33°C using a constant temperature bath and a mass flow controller specially designed to handle $SiHCl_3$ was used. In this case, the mass flow controller and the associated lines were traced with a heat tape and maintained at a temperature of 36°C to prevent $SiHCl_3$ condensation.

The polycrystalline Si was fabricated at a substrate temperature from 950-1200°C and furnace pressure of 25-400 torr. The other deposition conditions were: flow rates: $SiHCl_3$ - 0.8-1.5 slpm, $H_2$ = 3.0-9.0 slpm and Ar = 0.2 slpm.

The deposition was conducted in a horizontal three zone Lindberg furnace with a maximum temperature capability of 1500°C. The furnace support tube is made of alumina and water-cooled stainless steel injectors were used to inject a mixture of $SiHCl_3$, $H_2$ and Ar in the reaction zone. The deposition area consisted of four graphite plates, each 12 inches long and 3.5 inches wide arranged in the form of a open square box. The polycrystalline Si was deposited on the inside surface of this "box". A mould release coating was used on the graphite to facilitate recovery of Si without destroying the graphite mandrel. After the deposition, the products of reaction and unused reagents passed through a set of quartz filters that trapped any solid particules, and then the exhausts were neutralized in a KOH scrubber before they were vented through the atmosphere.

The polycrystalline Si was also successfully scaled from the horizontal research reactor to a vertical pilot plant size reactor, and Si plates 30 cm long x 25 cm wide x 0.625 cm thick were fabricated.

EXAMPLE 2

PRODUCTION OF CVD-SiC

SiC was produced in a low pressure CVD process to produce polycrystalline cubic (β) SiC based on the following chemical reaction:

$$CH_3SiCl_3(g) \xrightarrow[T,P]{H_2,Ar} Sic(S) + 3HCl(g)$$

where g and s refer to gaseous and solid species, respectively. The above reaction involves the pyrolysis of methyltrichlorosilane ($CH_3SiCl_2$) in excess hydrogen ($H_2$) to produce silicon carbide (SiC), and a byproduct of the reaction is hydrogen chloride (HCl).

The following are nominal run conditions to produce CVD-SiC in a 0.5 m diameter furnace:

| | |
|---|---|
| Temperature | 1350°C |
| Pressure | 200 torr |
| $Ch_3SiCl_3$ Flow Rate | 5.5 slpm |
| $H_2$ Flow Rate | 28 slpm |
| Argon (Ar) Flow Rate | 60 slpm |
| Deposition Rate | ~ 1.5 μm/min. |

EXAMPLE 3

Annealing Experiments on CVD-Si

Depositions/annealing experiments were performed as shown in Table 1.

Table 1. Details of Si Deposition/Annealing Experiments
Performed in the Research Furnace

| Run No. | Run Time hr | Substrate Temp. C | Furnace Press. torr | Flow Rate slpm Ar/$H_2$ | Ar/$H_2$ through $SiHCl_3$ | $SiHCl_3$ Tank Temp. C | Press. torr | Remarks |
|---|---|---|---|---|---|---|---|---|
| 1 | 48 | 1050 | 100 | $H_2$ = 10 | $H_2$ = 1.0 | 0.0 | 863 | $H_2$ purifier used. $SiHCl_3$ tank cooled with ice. |
| 2 | 5 | 1300 | 600 | 0.0 | - | - | - | Annealing run. Flush and evacuate cycle up to 1200 C. Material characterized. |
| 3 | 5 | 1300 | 600 | Ar = 2.0 | - | - | - | Annealing run. Material characterized. |

EP 0 494 753 A2

In deposition Run 1, silicon was deposited using ultra high purity reagents. Because the semiconductor industry routinely produces polycrystalline Si of superior transmission by the reaction of $SiHCl_3$ with $H_2$, it was decided to use the same CVD process conditions as are used by the semiconductor industry to fabricate Si. Because the semiconductor industry uses a hydrogen purifier to purify $H_2$ in real time, a $H_2$ purifier was utilized. Further, to reduce the fluctuations associated with $SiHCl_3$ flows due to change in tank temperature, the $SiHCl_3$ tank was immersed in an ice bath. Additionally, the $SiHCl_3$ was carried to the deposition area using $H_2$ as the carrier gas. The substrate temperature and furnace pressure were maintained at 1050°C and 100 torr, respectively. The flow rate of $H_2$ was 10 slpm (standard liter per minute) and the $H_2/SiHCl_3$ molar ratio was 25:1. The deposition was terminated after 48 hours.

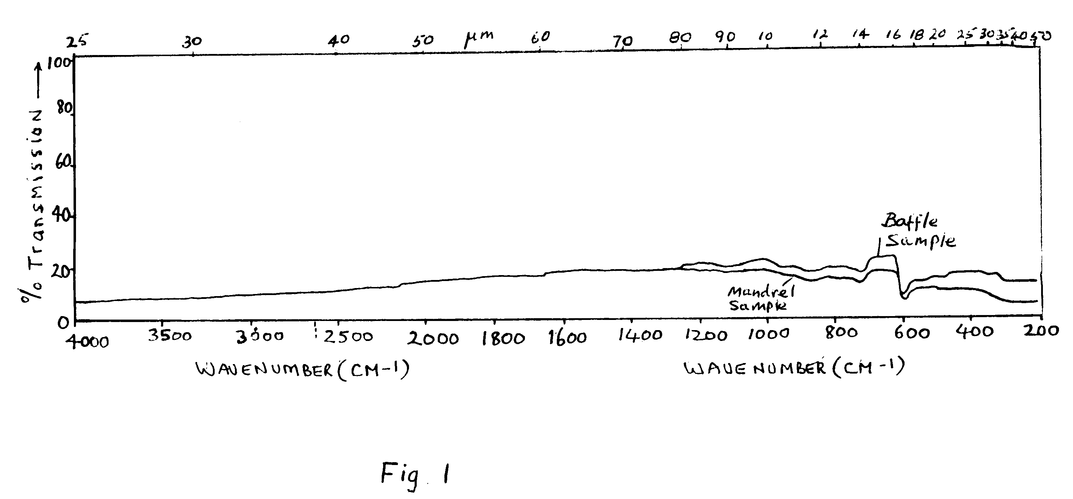

On examination, polycrystalline Si about 0.10-inch thick was deposited. This material was characterized for infrared transmission and crystal structure. Further, the microstructure of the material in the growth direction (i.e., cross section of the material) was also examined with a Nomarski microscope. These results are shown in FIGS 1 through 3. In FIG. 1 are shown infrared transmission traces of two samples of CVD-Si taken from two different locations in the deposition area (mandrel and baffle). The thickness of the sample was 0.067-inches. It is seen that the scattering effect in the form of reduced transmission in the near infrared region still exists. Further, the transmission of the material is quite low even in mid-infrared regions where almost theoretical transmission was obtained in previous depositions. It is not clear why there is degradation of transmission in the mid-infrared regions.

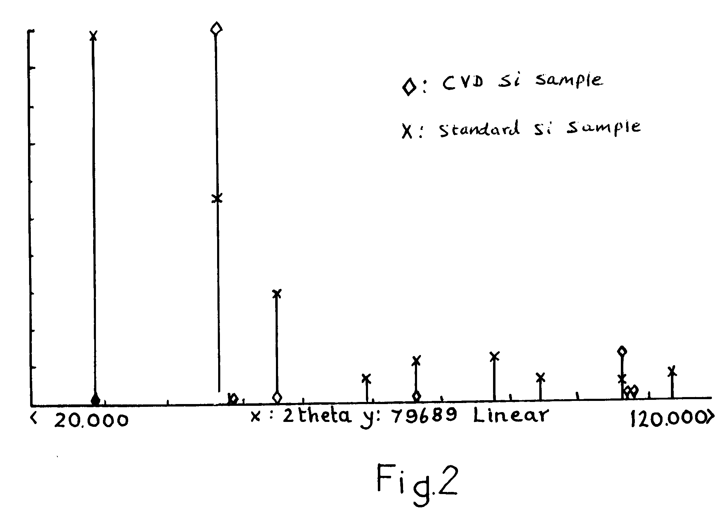

FIG. 2 shows the x-ray diffraction scan of a CVD-Si sample taken from the mandrel. This scan was obtained from the surface of that which faced the graphite substrate. However, x-ray difffraction scans taken of other samples and at other surfaces were also similar, but are not shown here. From FIG. 2 it is seen that the material is highly oriented in the (220) direction. This result is typical for polycrystalline Si fabricated at a high deposition temperature.

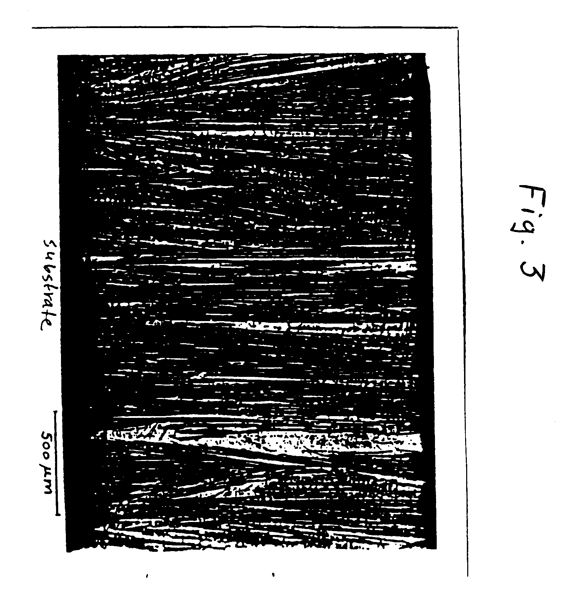

FIG. 3 shows the cross section (parallel to the growth direction) at 50 times magnification of the microstructure of a sample of CVD-Si which was polished and etched for one minute in a hot solution of 50% KOH. The columnar grain structure visible in this figure is typical of polycristalline Si that has been obtained in previous depositions. These results indicate that the use of high purity reagents, in particular $H_2$, does not improve the near-infrared transmission of CVD-Si.

In Run 2, CVD-Si was then subjected to a high temperature annealing treatment in a CVD reactor. Annealing of Si is also known to minimize residual stresses within the material. Therefore, in Run 2, a few small samples of polycrystalline Si, fabricated previously, (A, B and C) were loaded in the reactor. One reason for using samples from different deposition runs was to determine if the CVD-Si produced at different process conditions will anneal differently. In deposition Run A, the process conditions used were: substrate temperature = 1030-1070°C, furnace pressure = 200 torr, flow rate $H_2$ - 7.0 slpm, $SiHCl_3$ = 1.0, Ar = 0.6 slpm. Further, the flow of $SiHCl_3$ was pulsed with on time = 20 seconds and off time = 10 seconds. In deposition Run B, the process conditions used were the same as for Run A except that the substrate temperature was in the temperature range of 1030-1070°C. The deposition conditions for deposition Run C is not traceable at this time.

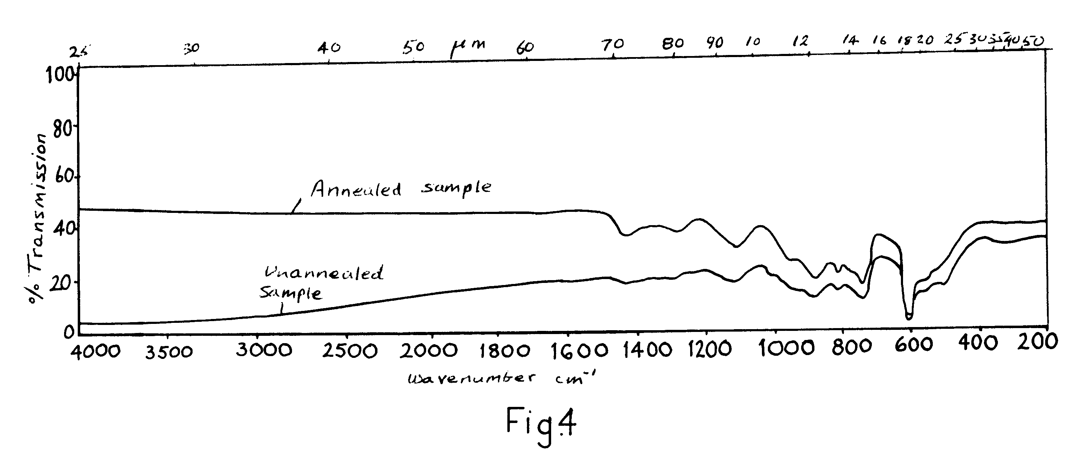

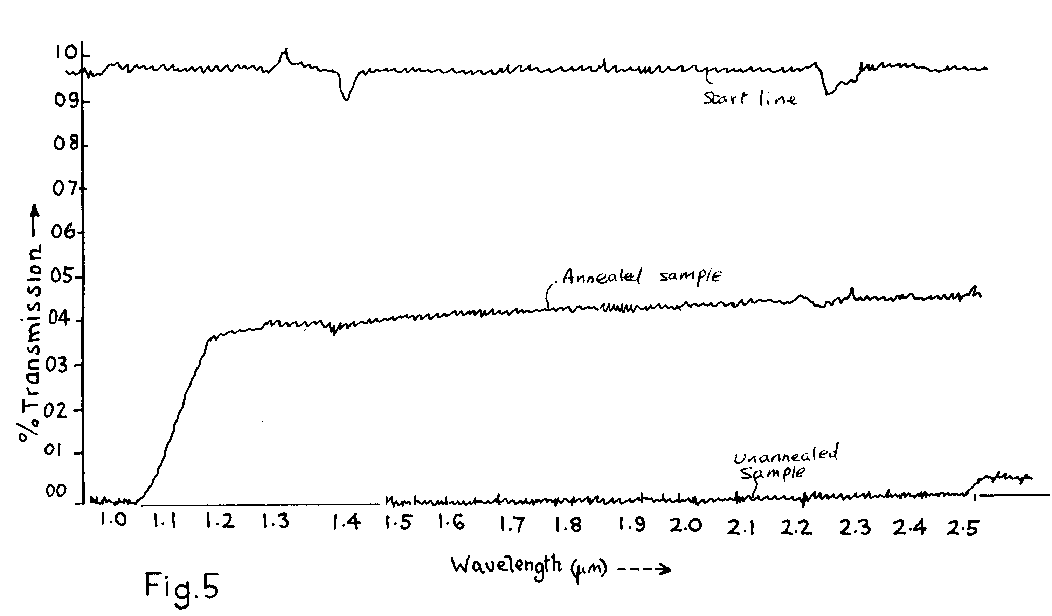

The CVD-Si samples from the deposition Runs A, B, and C were annealed at 1300°C for five hours. The annealing was performed at a furnace pressure of 600 torr and with no gas flow. Examination of the annealed material indicated formation of a SiC layer on both sides of the Si sample. The presence of this layer was confirmed by the reflection measurement and the x-ray diffraction analysis. This was understandable because at 1300°C, polycrystalline Si at the sample surface reacts with carbon from the deposition setup to form SiC. The SiC layer was thin and easily removed by grinding the sample on both sides. The samples were then polished and characterized for infrared transmission, hardness, and crystal structure. These results are shown in FIGS. 4 through 10. In FIGS. 4 and 5, there is shown a comparison of infrared transmission of unannealed and annealed samples from Run A in the range 2.5 μm-5 μm and 1.0 μm-2.5 μm, respectively. The thickness of the annealed sample was 0.135-inch, while that of the unannealed sample was 0.150-inch. From FIGS 4 and 5, there is seen a dramatic improvement in the transmission of annealed CVD-Si throughout the infrared region. The transmission of the annealed sample is very close to that of the single crystal Si. These data show that CVD-Si perhaps has some residual stresses or crystal disorder that is removed during annealing.

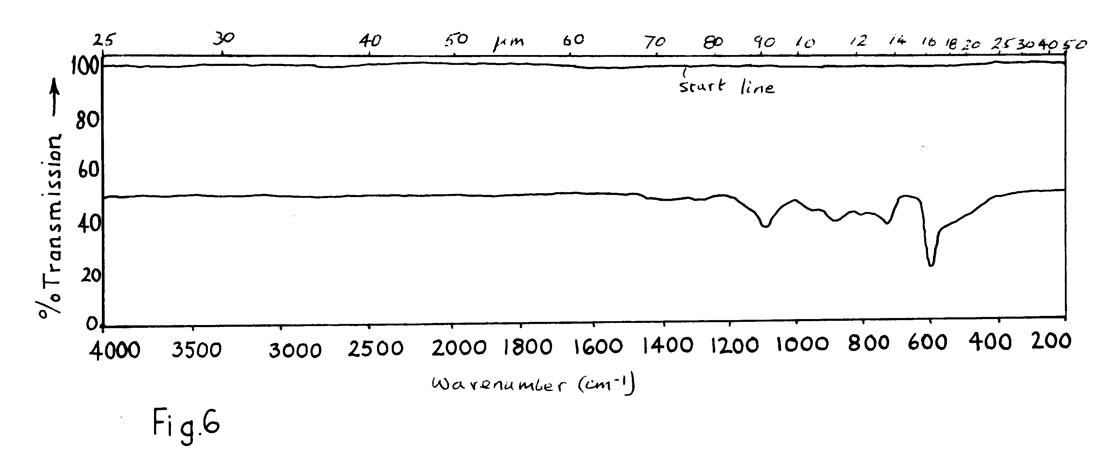

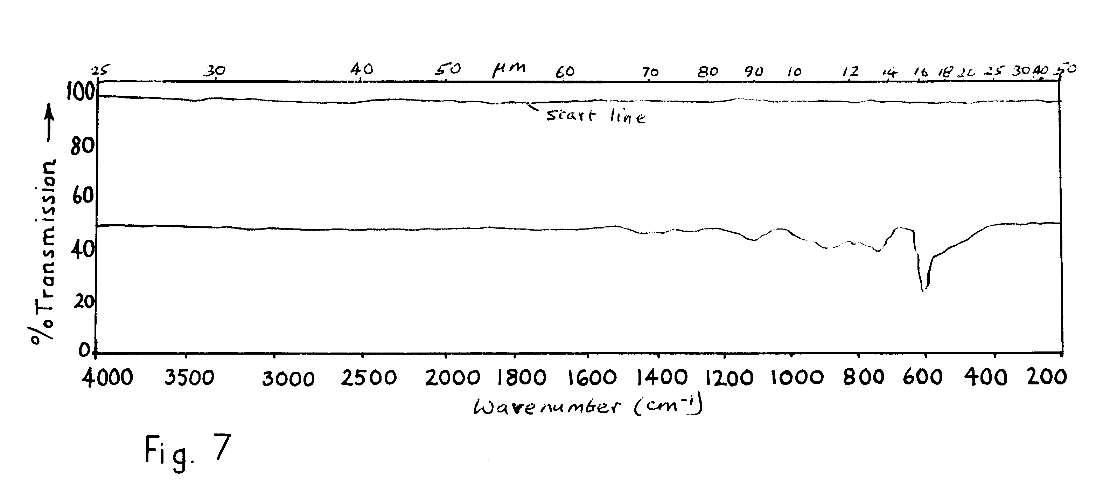

The infrared transmission traces of samples produced in deposition Runs B and C are shown in FIGS. 6 and 7, respectively. Again, it is seen that there is considerable improvement of transmission in the near-infrared region in the annealed samples. These results show that annealing improves the transmission of CVD-Si produced at several different CVD conditions, i.e., deposition temperature 1010-1070°C, and apparently it is independent of whether the flow of $SiHCl_3$ is pulsed or not.

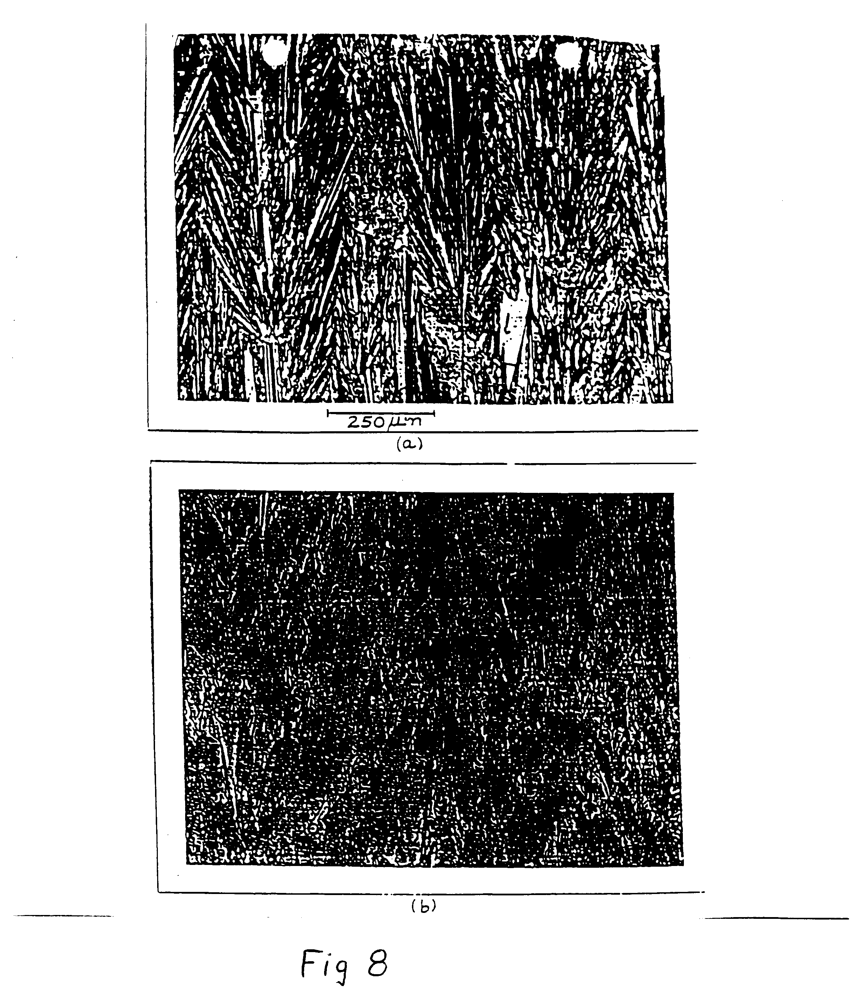

In order to determine if the annealing treatment also affects other properties of CVD-Si, the material was also characterized for microstructure, crystal structure, and hardness. FIG. 8 shows a comparison of microstructure, parallel to the growth direction and magnified 100 times, of annealed and unannealed samples of CVD-Si produced in deposition Run A. It is seen that the columnar growth structure so characteristic of CVD-Si (FIG. 8[a]) totally disappears after annealing, and distinct grain boundaries are visible. These grain boundaries usually appear when the microstructure is taken perpendicular to the growth direction. Thus, the appearance of these distinct grain boundaries indicates that a rearrangement of different crystallites has occurred, thereby producing a more isotropic material.

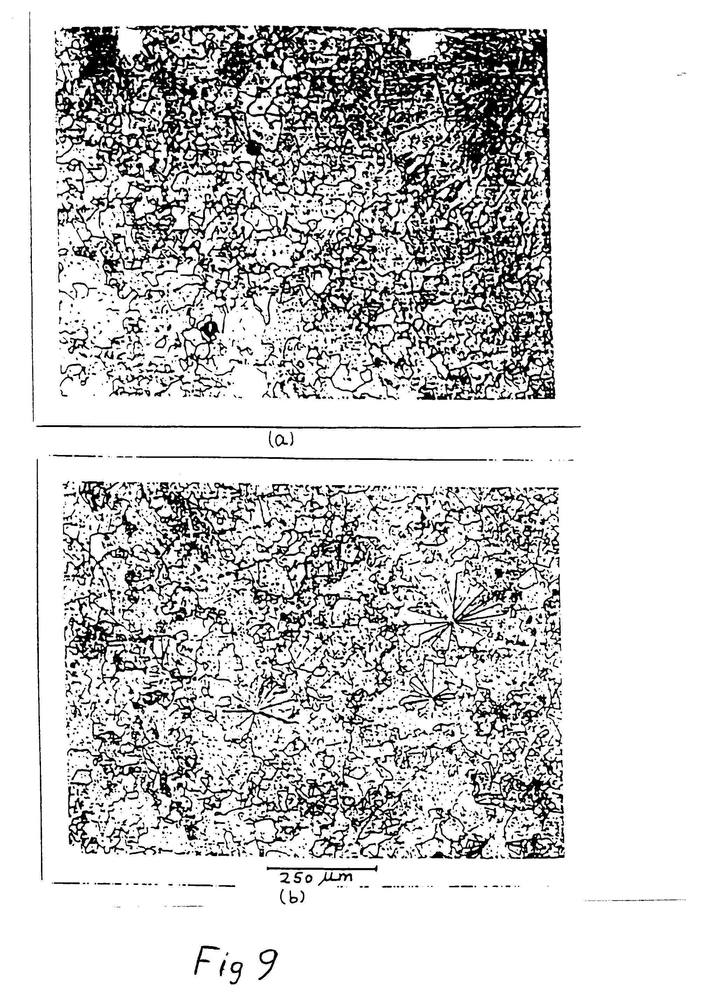

FIG. 9 shows the microstructure taken from two different locations on the surface of annealed sample of CVD-Si produced in Run C. These micrographs were taken perpendicular to the growth direction at 100 times magnification. It is seen that the rosette pattern so characteristic of CVD-Si has totally disappeared at one location (FIG. 9[a]), while at the other location (FIG. 9[b]) it is considerably reduced. However, the average grain size has not changed due to annealing. This means that mechanical properties, such as hardness and flexural strength, should not change appreciably due to annealing.

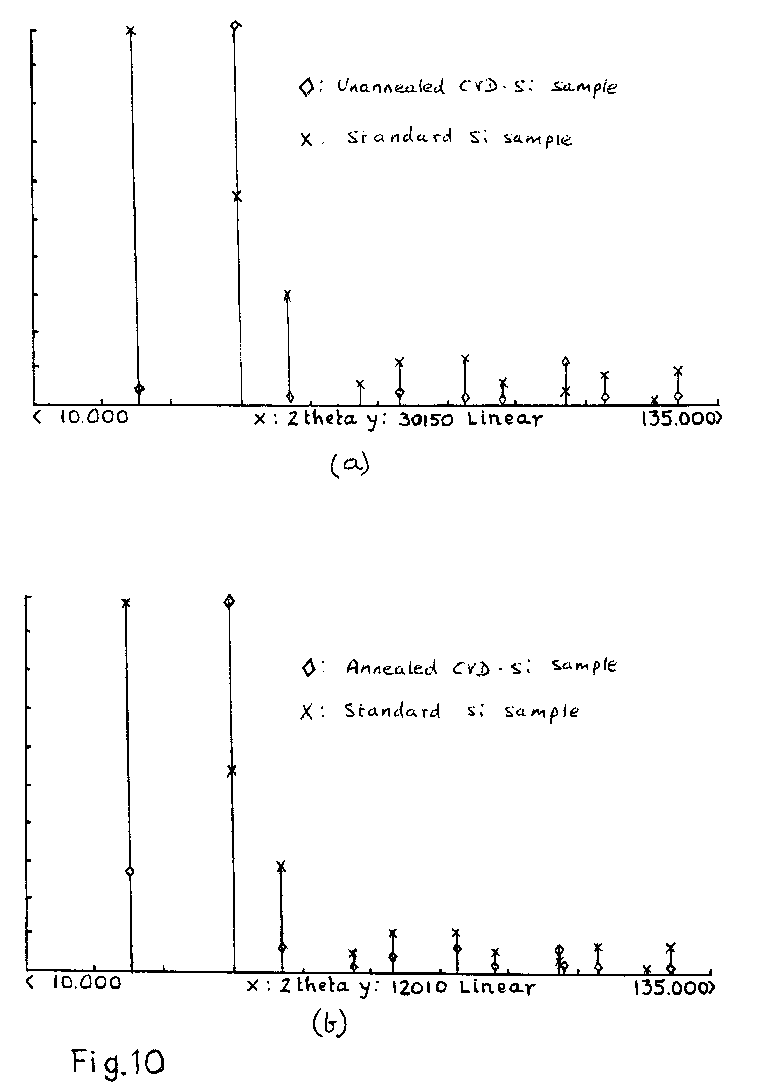

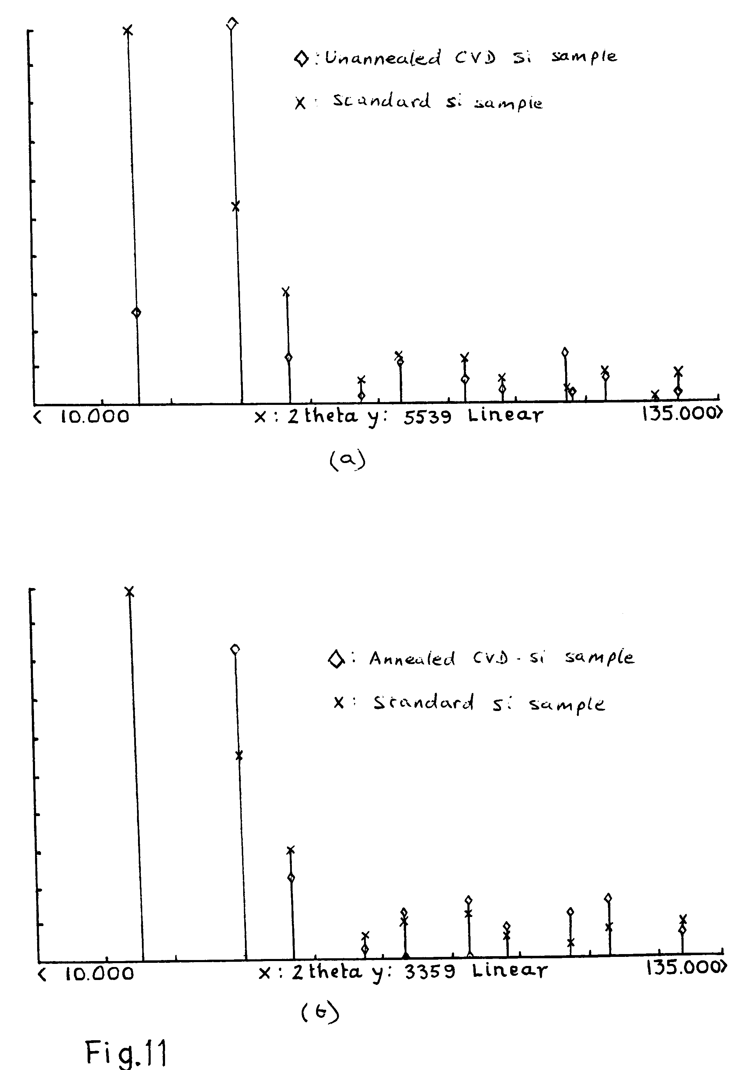

FIGS. 10 and 11 show a comparison of x-ray diffraction scan of sides 1 and 2, respectively, of unannealed and annealed samples of CVD-Si fabricated in deposition Run A. On both sides of the sample, it is seen that the annealing operation has changed the crystal structure from one of preferred orientation to that of more random orientation. This result is in conformity with the microstructure data as discussed above.

In Table 2, there is shown a comparison of Knoop hardness (kg mm$^{-2}$) of unannealed and annealed samples of CVD-Si produced in Run A. The indentation was made with a load of 0.200 kg for 10 seconds to obtain the hardness data.

EP 0 494 753 A2

Table 2. Knoop hardness of unannealed and annealed samples of CVD-Si
fabricated in Run  A    .  The annealing run
number was    2, load = 0.2 kg, time = 10 sec

| | Unannealed Sample | | | | Annealed Sample | | | |
| | Side 1 | | Side 2 | | Side 1 | | Side 2 | |
| S No. | Indentation Length ($\mu$m) | Hardness (kg mm$^{-2}$) | Indentation Length ($\mu$m) | Hardness (kg mm$^{-2}$) | Indentation Length ($\mu$m) | Hardness (kg mm$^{-2}$) | Indentation Length ($\mu$m) | Hardness (kg mm$^{-2}$) |
|---|---|---|---|---|---|---|---|---|
| 1 | 60.1 | 787.8 | 58.8 | 823.0 | 58.4 | 834.4 | 58.5 | 831.5 |
| 2 | 60.4 | 780.0 | 59.9 | 793.1 | 56.2 | 901.0 | 58.8 | 823.0 |
| 3 | 57.3 | 866.7 | 57.3 | 866.7 | 58.8 | 823.3 | 58.5 | 831.5 |
| 4 | 58.3 | 837.2 | 58.5 | 831.5 | 57.4 | 863.7 | 58.4 | 834.4 |
| 5 | 57.7 | 854.7 | 58.4 | 834.4 | 56.4 | 894.6 | 56.5 | 891.4 |
| 6 | 57.8 | 851.8 | 59.4 | 806.5 | - | - | 57.0 | 875.8 |
| 7 | 58.3 | 837.2 | 60.8 | 769.8 | 58.0 | 845.9 | 58.1 | 843.0 |
| 8 | 59.8 | 795.7 | 58.4 | 834.4 | 58.7 | 825.8 | 60.1 | 787.8 |
| 9 | 60.4 | 780.0 | 58.4 | 834.4 | 56.9 | 878.9 | 58.5 | 831.5 |
| 10 | 57.9 | 848.8 | 58.1 | 843.0 | 58.3 | 837.2 | 59.0 | 817.5 |
| Average | | 824.0 | | 823.7 | | 856.1 | | 836.7 |
| Standard Deviation | | 34.1 | | 27.4 | | 29.6 | | 29.1 |

Average Knoop hardness of unannealed sample (all points) = 824 ± 30

Average Knoop hardness of annealed sample   (all points) = 846 ± 30

It is seen that the average Knoop hardness of the annealed sample is $846 \pm 30$ which is approximately the same as that of unannealed sample ($824 \pm 30$) within the accuracy of measurement. Thus, it is seen that the annealing operation does not appreciably alter the material hardness. This result is in conformity with the grain size data as discussed above.

In Run 3, the annealing conditions of Run 2 were essentially repeated on some more samples of CVD-Si to determine if improvement in infrared transmission can be obtained in a reproducible manner. Another aim of this annealing experiment was to use relatively thicker samples such that flexural strength and elastic modulus data can be obtained. The samples were fabricated from CVD-Si produced in deposition Run D. The CVD process conditions for this deposition were as follows: substrate temperature = 990°C, furnace pressure = 200 torr, flow rates, $H_2$ = 7 slpm, $SiHCl_3$ = 1.2 slmp. This deposition yielded about 6-mm-thick material. The annealing conditions used were: Substrate temperature = 1300°C, furnace pressure = 600 torr, Ar flow rate = 2.0 slpm. annealing time = 5 hours. (It should be noted that in annealing Run 2, no gas flow was used during annealing.)

Several different types of CVD-Si samples were loaded in Run 3. Some samples were placed on the graphite plates whereas some samples were individually sandwiched in between two Si samples, two SiC samples, and quartz samples. The aim of these experiments was to determine: (i) if sandwiching the CVD-Si will prevent formation of SiC on the Si surface and (ii) if the annealing process will still work and improve the transmission of CVD-Si.

Examination of the annealed samples showed that SiC had been formed on the surface of all CVD-Si samples placed on graphite, while no SiC layer was observed on sandwiched Si samples. This shows that formation of SiC is due to the exposure of CVD-Si to graphite inside the CVD reactor. Further, x-ray diffraction scans of CVD-Si samples sandwiched between quartz and CVD-Si samples were also obtained. These traces indicate the x-ray diffraction pattern corresponding to a random orientation as opposed to preferred (220) orientation for unannealed samples. These results show that annealing process also works for sandwiched CVD-Si samples in a manner similar to other samples.

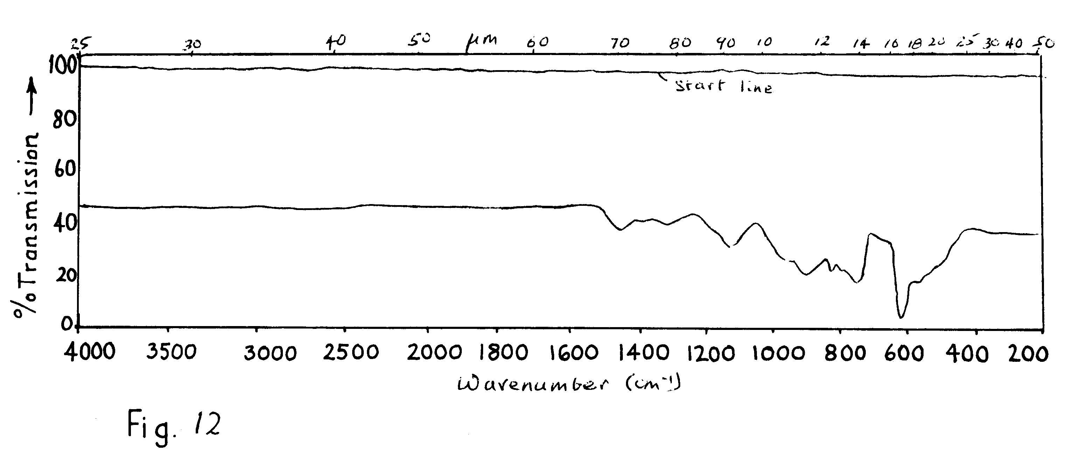

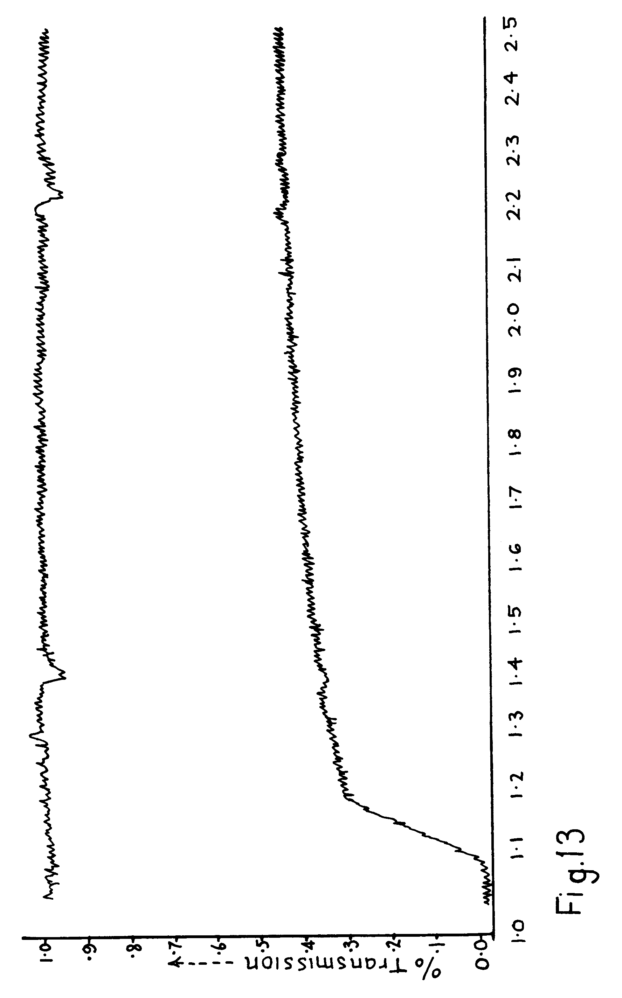

FIGS. 12 and 13 show the infrared transmission of CVD-Si samples fabricated in deposition Run D in the wavelength range 2.5 $\mu$m - 50 $\mu$m and 1.0 $\mu$m - 1.5 $\mu$m, respectively. The sample thickness was 0.133-inch. Identical results for transmission were obtained, as before, although the CVD process conditions used to fabricate this sample were considerable different from those used previously. These results indicate that annealing process works for CVD-Si fabricated over a wide range of CVD conditions. Further, it also shows that the improvement in transmission is independent of the flow of Ar during the annealing process.

Table 3 shows the four-point bend test results on annealed samples of CVD-Si produced in Run D. The samples were nominally polished. The length of the specimen was 50 mm.

Table 3. Four-Point Bent Test Results of Annealed
Samples of CVD-Si

| Sample Number | Sample Thickness mm | Sample Height mm | Load kg | Flexural Strength | | Elastic Modulus | |
|---|---|---|---|---|---|---|---|
| | | | | Ksi | MPa | x 10⁶ psi | GPa |
| 1 | 4.67 | 3.33 | 22.73 | 18.7 | 129.3 | 20.8 | 143.8 |
| 2 | 4.67 | 3.38 | 29.09 | 23.2 | 160.4 | 21.1 | 145.8 |
| 3* | 4.67 | 3.33 | 13.2 | 10.8 | 74.6 | 19.6 | 135.5 |
| 4 | 4.67 | 3.35 | 32.3 | 26.2 | 181.1 | 19.8 | 136.9 |
| 5 | 4.67 | 3.35 | 21.8 | 17.7 | 122.3 | 20.0 | 138.2 |
| 6 | 4.67 | 3.35 | 40.5 | 32.8 | 226.7 | 20.9 | 144.5 |
| 7 | 4.67 | 3.35 | 27.7 | 22.5 | 155.5 | 20.2 | 139.6 |

*Sample 3 had a large visible flaw on the surface.

| | Ksi | MPa | x 10⁶ psi | GPa |
|---|---|---|---|---|
| Average (excluding Sample 3) | 23.5 | 162.4 | 20.5 | 141.7 |
| Standard Deviation (excluding Sample 3) | 5.5 | 38.0 | 0.5 | 3.5 |

From Table 3, it is seen that the flexural strength and elastic modulus of the annealed material varies respectively from 74.6 MPa (10.8 Ksi) to 226.7 MPa (32.8 Ksi) and from 135.5 GPa (19.6 x 10⁶ psi) to 144.5 GPa (20.9 x 10⁶ psi). Because sample #3 had a large visible flaw on the surface, this data point is ignored. Consequently, excluding sample #3, the average flexural strength and elastic modulus of the material is 162.4 ± 38 MPa (23.5 ± 5.5 Ksi) and 141.7 ± 3.5 GPa (20.5 ± 0.5 x 10⁶ psi). For unannealed material from the same run, flexural strengths of 221 ± 33 MPa (32 ± 4.8Ksi) for polished and etched samples, 321.1 ± 33 MPa (30.5 ± 4.7 Ksi) for highly polished samples and 107 ± 17 MPa (15.5 ± 2.5 Ksi) for unpolished samples were obtained. Thus, the data for annealed samples which were nominally polished lie in between those of the highly polished (or polished and etched) and unpolished but unannealed samples. Thus, it is concluded that within the accuracy of measurement, the flexural strength of the annealed samples is close to that of the unannealed samples. In a similar manner, the elastic modulus of unannealed samples was measured to be 161 GPa (23.3 x 10⁶ psi) which is also close to that of the annealed samples. Thus, annealing of the samples does not appreciably degrade the mechanical properties of CVD-Si. This result is in conformity with the grain size data as presented above for Run 2.

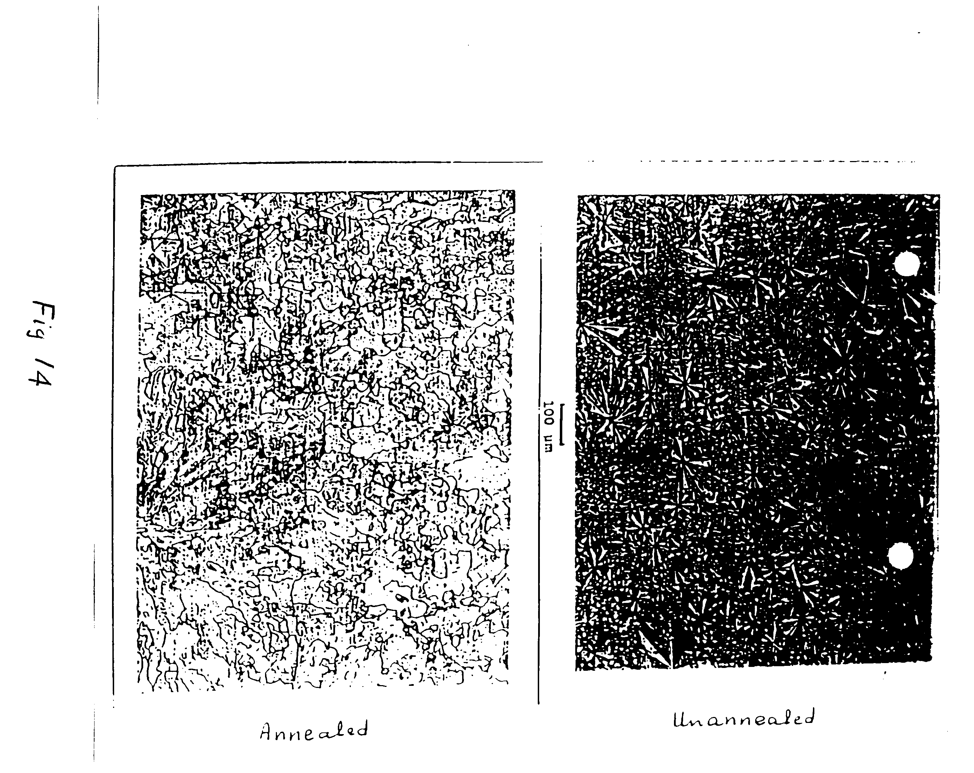

FIG. 14 shows a comparison of microstructure taken perpendicular to the growth direction at 100 times magnification of annealed and unannealed samples of CVD-Si fabricated in Run D. In the micrograph of unannealed sample(FIG. 14[a]), the rosette pattern showing a bimodal grain size distribution is clearly visible. However, after annealing, the grain size distribution is more random.

EXAMPLE 4

Annealing Experiments on CVD-SiC

A total of three annealing experiments were performed. The details of these experiments are given in Table 4.

Table 4. Details of CVD SiC Annealing Experiments Performed
in the Research Furnace

| Run No. | Run Time | Substrate Temp. C | Furnace Pressure torr | Ar Flow Rate slpm | Environment | Remarks |
|---------|----------|-------------------|----------------------|-------------------|-------------|---------|
| I | 5 | 1800 | 600 | 0.0 | Si vapor | Several SiC and Si samples were placed on graphite plates. Si vaporized at 1800 C to provide Si vapor environment. Ar flow stopped when temp = 1450 - 1800 C. |
| II | 24 | 1850 | 600 | 2.0 | Si vapor | Several SiC and Si were samples loaded in a closed graphite container with a small hole. |
| III | 25 | 1800 | 600 | 0.0 | Si vapor | Several SiC and Si samples were placed on a graphite plate. |

In Run I, several samples of CVD-SiC and CVD-Si fabricated in previous depositions were placed on a graphite plate. CVD-Si samples were kept along with CVD-SiC because at 1800°C, Si has a high vapor pressure and provides an environment of Si vapors in the furnace during annealing. The annealing conditions used were: substrate temperature = 1800°C, furnace pressure = 600 torr. Further, an Ar flow of 2.0 slpm was maintained in the reactor up to a temperature of 1450°C. This flow was stopped when the substrate temperature was in the range of 1450-1800°C to prevent loss of Si vapors from the reactor. The annealing experiment was terminated after the samples were maintained at 1800°C for five hours.

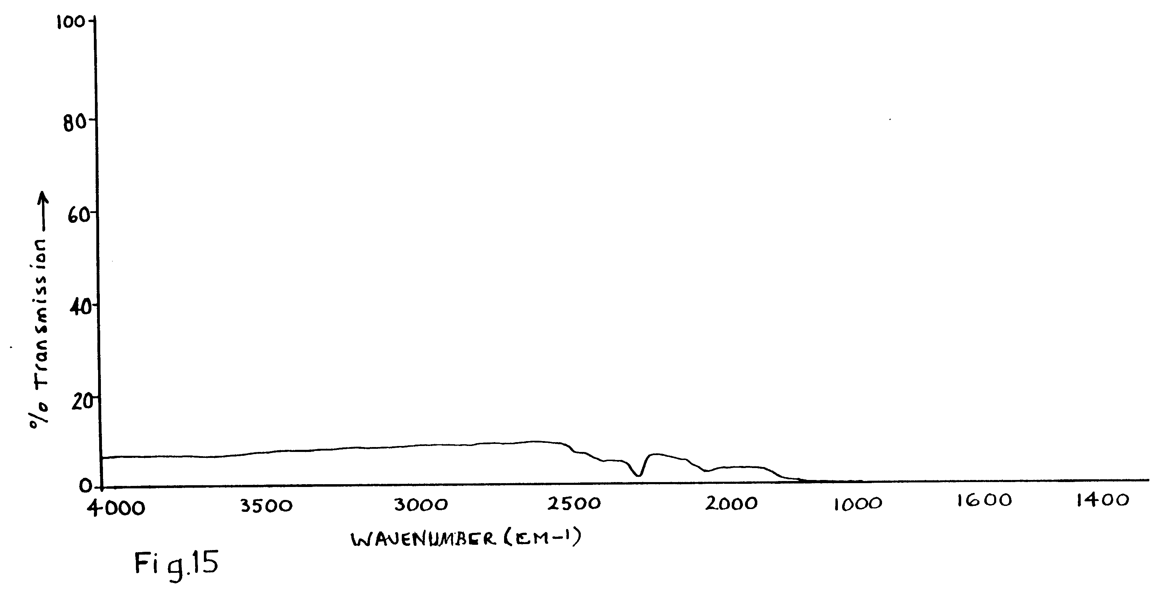

On examination, a thin layer of greenish powder was detected near the SiC samples. This powder appeared to be SiC and perhaps was formed by the reaction of Si vapors with the surrounding graphite in the reactor. Visual examination of the samples revealed the presence of a thin transparent layer of SiC on top of each sample. One annealed sample of SiC was polished on both sides and characterized for infrared transmission and hardness. FIG. 15 shows the infrared transmission of this sample. The thickness of the sample is about 0.080-inch. We see that there is about 7% transmission in the wavelength range 2.5 μm-4.0 μm. This preliminary deposition is quite encouraging and essentially shows that the annealing technique can potentially improve CVD-SiC transmission.

The Knoop hardness of the polished samples is shown in Table 5. The applied load was 500 grams and the indentation time was 10 seconds.

Table 5. Knoop Hardness of Annealed Sample of CVD SiC, Run No. 1

Applied Load = 500 grams
Time        = 10 sec

| Sample No. | Substrate-Side Surface | | As-Deposited Surface | |
|---|---|---|---|---|
| | Indentation Length (μm) | Hardness (kg mm$^{-2}$) | Indentation Length (μm) | Hardness (kg mm$^{-2}$) |
| 1 | 56.3 | 2244.5 | 56.8 | 2205.1 |
| 2 | 56.8 | 2205.1 | 56.8 | 2205.1 |
| 3 | 58.1 | 2107.6 | 58.8 | 2057.7 |
| 4 | 56.4 | 2236.5 | 57.3 | 2166.8 |
| 5 | 58.2 | 2100.3 | 56.8 | 2205.1 |
| 6 | 56.1 | 2260.5 | 56.9 | 2197.6 |
| 7 | 56.9 | 2197.4 | 58.0 | 2114.8 |
| 8 | 57.5 | 2151.8 | 57.1 | 2182.0 |
| 9 | 56.5 | 2228.6 | 56.6 | 2220.8 |
| 10 | 59.1 | 2036.8 | 57.2 | 2174.4 |
| Average | | 2177 ± 75 | | 2173 ± 50 |

Average Knoop hardness (all points) = 2175 ± 62

It is seen the hardness of both surfaces, substrate side and as-deposited, is the same within the accuracy of measurement. The average Knoop hardness for an annealed sample is 2175 ± 62 kg mm$^{-2}$ which is about 13% less than the average Knoop hardness of unannealed SiC (2500 kg min$^{-2}$).

In Run II (SiC), (i) the annealing time has increased from 5 hours to 24 hours and (ii) the sample temperature from 1800°C to 1850°C. In addition, to maintain a constant concentration of Si vapors over SiC samples throughout the annealing period, a few samples of SiC and Si were loaded in a graphite container which was sealed from all sides except for a small hole. The graphite container was placed in the CVD reactor, and Ar was passed at the rate of 2.0 slpm. After the experiment was completed, it was noticed that all the Si was used up. The SiC samples were polished on both sides and characterized for infrared transmission. No change in transmission was detected between annealed and unannealed samples.

In Run III, it was decided to essentially repeat the conditions of Run I (SiC), except that the annealing time was changed from 5 hours to 25 hours. Samples of SiC fabricated in two different depositions , Runs E and F, were loaded along with some Si samples in the reactor. The specific CVD process conditions for these depositions E and F are listed in Table 6.

Table 6. CVD process conditions for the deposition of SiC in Run E : and Run F

| | Run E | Run F |
|---|---|---|
| Substrate Temperature | 1350° C | 1380° C |
| Furnace Pressure | 200 torr | 200 torr |
| Flow rate: | | |
| H$_2$ (6 outer injectors) | 4.5 slpm ea | 4 slpm ea |
| H$_2$ (central injector | 4.0 slpm | 4.0 slpm |
| Ar (6 outer injectors) | 9.0 slpm ea | 8.1 slpm ea |
| Ar (central injector) | 9.5 slpm | 8.0 slpm |
| MTS (6 outer injectors) | 0.83 slpm ea | 0.74 slpm ea |
| MTS (central injector) | 0.81 slpm | 0.79 slpm |
| Mandrel Setup | 0.5 m plate | Two 0.25 m plates |

It is seen that the primary difference between the two depositions was the substrate temperature and the mandrel setup.

After the annealing experiment was completed, the SiC samples were polished and characterized for infrared transmission. The annealed SiC sample fabricated in Run F did not show any change in transmission, whereas the infrared transmission of annealed sample of SiC fabricated in Run E improved as shown in FIG. 16. Although the sample thickness was relatively small, i.e., 0.024-inch, a transmission of about 20% between the wavelength range 2.5-4.0 μm is quite significant.

## Claims

1. A process for improving the optical transmission of silicon produced by a chemical vapor deposition process, which comprises the step of annealing said silicon at a temperature from 1300°C to 1500°C.

2. Chemical vapor deposition-produced silicon having an attenuation coefficient at 3500 cm$^{-1}$ of not more than 0.3 cm$^{-1}$.

3. Chemical vapor deposition-produced silicon according to Claim 2 having an attenuation coefficient at 3500 $cm^{-1}$ of not more than 0.01 $cm^{-1}$.

4. Silicon according to Claim 2 or Claim 3 having a Knoop hardness of at least 800 Kg $mm^{-2}$.

5. Silicon according to any one of Claims 2 to 4 having a flexural strength of at least 20,000 psi (137.89 MPa).

6. Silicon according to any one of Claims 2 to 5 having an elastic modulus of at least about $20 \times 10^{6}$ psi (137.89 GPa).

7. A process of producing optically transmitting silicon which comprises producing a silicon deposit on a substrate by pyrolyzing $SiHCl_3$ in excess $H_2$ at a deposition temperature below 1100°C and subsequently annealing said deposited silicon at a temperature from 1300°C to 1500°C.

8. A process for improving the optical transmission of silicon carbide produced by a chemical vapor deposition process, which comprises the step of annealing said silicon carbide at a temperature from 1800°C to 2600°C.

9. A process according to Claim 8 wherein said silicon carbide is annealed at a temperature from 1800°C to 2300°C.

10. A process according to Claim 9 wherein said silicon carbide is annealed at a temperature from 2200°C to 2300°C.

11. Chemical vapor deposition-produced silicon carbide having an attenuation coefficient at $3500^{-1}$ of not more than 4 $cm^{-1}$.

12. Silicon carbide according to Claim 11 having a Knoop hardness of at least 2100 Kg $mm^{-2}$.

13. A process for improving the optical transmission silicon or silicon carbide produced by a chemical vapor deposition process, which comprises the step of annealing the silicon or silicon carbide at a temperature in the region of its melting point.

EP 0 494 753 A2

Fig. 1

16

Fig.2

◇ : CVD Si Sample

X : Standard Si Sample

x : 2theta y: 79689 Linear

< 20.000

120.000 ◇

Fig. 3

Fig.4

Fig.5

Start line

Annealed sample

Unannealed Sample

%Transmission →

Wavelength (μm) ---→

1.0  1.1  1.2  1.3  1.4  1.5  1.6  1.7  1.8  1.9  2.0  2.1  2.2  2.3  2.4  2.5

Fig.6

Fig. 7

250 μm

(a)

(b)

Fig 8

(a)

250 μm

(b)

Fig 9

◇: Unannealed CVD·Si sample

X: Standard Si sample

X: 2 theta y: 30150 Linear

〈 10.000 ... 135.000〉

(a)

◇: Annealed CVD·Si sample

X: Standard Si sample

X: 2 theta y: 12010 Linear

〈 10.000 ... 135.000〉

(b)

Fig.10

Fig.11

Fig. 12

Fig.13

EP 0 494 753 A2

100 μm

Unannealed

Annealed

Fig 14

Fig.15